# EUROPEAN PATENT SPECIFICATION

(11) **EP 1 633 516 B1**
(45) Date of publication and mention of the grant of the patent: **07.07.2010**
(21) Application number: 04734547.5
(22) Date of filing: 24.05.2004
(51) Int. Cl.: B23B 31/20, B23B 31/26

(54) **ROTARY TOOL HOLDER ASSEMBLY AND METHOD OF ITS PRODUCTION**
ROTIERENDE WERKZEUGHALTERANORDNUNG UND VERFAHREN ZUR IHREN HERSTELLUNG
ASSEMBLAGE DE PORTE-OUTIL ROTATIF ET SON PROCÉDÉ DE FABRICATION

(30) Priority: 22.05.2003 GB 0311852
(43) Date of publication of application: 15.03.2006
(73) Proprietor: GSI Group Limited, Swift Valley Rugby Warwickshire CV21 1QN (GB)
(72) Inventor: PAVEY, Christopher, John, Colehill Wimborne Dorset BJ21 2NT (GB); Tempest, Michael, Clinton, Poole Dorset HB17 8QQ (GB)
(74) Representative: Faulkner, Thomas John
(86) International application number: PCT/GB2004/002214
(87) International publication number: WO 2004/103619

(56) References cited:
- DE-A- 3 635 910
- GB-A- 1 216 694
- GB-A- 2 002 660
- US-A- 3 625 528
- US-A- 5 078 558
- US-A- 5 820 136
- PATENT ABSTRACTS OF JAPAN vol. 2000, no. 06, 22 September 2000 (2000-09-22) -& JP 2000 071115 A (TOYOTA MOTOR CORP), 7 March 2000 (2000-03-07)

## Description

This invention relates to a rotary tool holder assembly, particularly to a rotary tool holder assembly used in the printed circuit board manufacturing industry, and to a method of producing such a rotary tool holder assembly.

Typically, rotary tool holder assemblies are used in the printed circuit board manufacturing industry for high speed drilling or high speed machining using router bits.

Such rotary tool holders need a simple and effective means for gripping the tool for operation because of the high speeds of rotation used.

Because a relatively large number of tools will be used over time, rotary tool holders, and especially their mechanism for clamping and releasing tools are susceptible to wear.

Conventionally greases are used on surfaces within rotary tool holders which are liable to wear.

Furthermore, in at least some types of rotary tool holders, very low friction sliding between moving components within the tool holder can be important for providing a sufficiently strong grip on an inserted tool to allow proper operation. The provision of grease on the appropriate surfaces can at least initially provide the desired low friction between the sliding surfaces. However, if grease is lost or dries, the frictional forces will increase, impairing the performance of the rotary tool holder.

If the gripping force of a rotary tool holder reduces to the point where tool slippage occurs during use, damage can be caused to the tool holder assembly and the tool. Typically a rotary tool holder assembly will comprise a collet in which the drill shank is held and this collet is particularly susceptible to damage. Other components in the rotary tool holder assembly can suffer fretting damage to their surfaces.

Greasing is almost universally used at present but has disadvantages. Firstly, whilst grease may be applied to almost any surface during the original manufacture of the tool holder, the further application of grease as part of a servicing operation can be difficult or impossible. Furthermore, in the high speed drilling and machining operations with which this application is particularly concerned, grease can be driven out from its desired location due to centrifugal effects.

Therefore, over the life of a rotary tool holder its performance can be significantly degraded due to wear and lack of lubrication.

JP 2000 071115 describes a rotary tool holder assembly according to the preamble of claim 1 comprising a taper collet which is arranged in a taper hole in a holder body. A spring is provided for forcing the collet into the hole if it tends to ride up out of the hole.

It is an object of this invention to provide rotary tool holder assemblies which alleviate at least some of the problems associated with the prior art.

According to the present invention there is provided a rotary tool holder assembly for high speed rotation according to claim 1 and a method of producing the rotary tool holder according to claim 9. The rotary tool holder of the present invention comprises a collet and a shaft, the collet being moveable relative to the shaft between a tool gripping position, in which an inserted tool can be gripped for rotation, and a tool release position, the shaft comprising a bore for receiving the collet, the shaft and collet shaped such that when the rotary tool holder assembly is rotated at a high speed the inner surface of the shaft bore substantially fits the outer surface of the collet wherein the outer surface of the collet and the inner surface of the shaft are tapered, the collet and the shaft bore tapering radially inwardly away from a tool receiving mouth of the collet. The tapers are such that when the rotary tool holder is stationary, the taper angle of the collet is grater than the taper angle of the shaft and at least one of the shaft and the collet is arranged such that when the rotary tool holder assembly is rotated at a high speed there is relative deformation between the outer surface of the collet and the inner surface of the shaft bore to give the substantial fit therebetween and wherein a friction reducing coating is provided between at least a portion of the inner surface of the shaft and the outer surface of the collet.

According to the method of claim 9, the low friction coating is applied at low temperature to avoid changing the properties of the material of the coated component.

In this specification, a friction reducing coating is a coating which gives rise to a lower frictional force between relatively moving parts than would occur if the coating were not present.

The rotary tool holder will typically be arranged for high speed rotation which would typically be in excess of 80,000 rpm. The tool to be gripped will typically be a drill bit or a router bit.

Preferably, at least one portion of the collet is coated with a friction reducing coating.

At least part of an outer surface of the collet which faces the internal surface of the shaft bore may be coated with a friction reducing coating. Part or all of the internal surface of the shaft bore may be coated with a friction reducing coating.

The collet may comprise a plurality of jaw portions for gripping an inserted tool. Typical numbers of jaw portions are three, four, six or eight.

The tapers of the collet and shaft may be such that axial movement of the collet relative to the shaft causes or allows the jaw portions of the collet to move in a direction transverse to the axis of the collet for gripping and releasing of an inserted tool. Preferably the tapering is such as to force the jaw portions into gripping contact with an inserted tool under movement of the collet relative to the shaft in one direction and the collet is arranged so that the jaw portions are biased away from gripping contact, so that an inserted tool will tend to be released as the result of movement of the collet relative to the shaft in the opposite direction.

The taper surfaces of the collet and/or the shaft may be coated with a friction reducing coating. It is particularly prefered for some or all of the taper surface of the collet to be coated with a friction reducing coating.

The taper angle is the acute angle of the taper relative to the axis about which the tool holder assembly is arranged for rotation. The difference in taper angle between the taper of the shaft and the taper of the collet may be between 1 and 10 arc minutes.

The collet will typically be generally cylindrical and substantially the whole of the outer curved surface of the cylinder may be coated with the friction reducing coating.

The shaft will typically be arranged to be journalled in a tooling machine. The surfaces of the shaft which are arranged to be received in the bearing(s) of the tooling machine may be coated with a friction reducing coating.

In one set of embodiments the collet may be carried by a bobbin arranged for axial movement within the bore of the shaft. The collet may be carried on the bobbin by virtue of being mounted on a stud retained within the bobbin. A guidebush insert may be provided within the bore of the shaft and the bobbin arranged for axial movement within the guide bush. Spring means may be provided for biasing the collet towards the gripping position. The spring means may be arranged for acting on the bobbin to bias the collet towards the gripping position. The spring means may be disposed in a spring receiving bore which may be provided in the shaft.

At least a portion of one of, or any combination of, the following components may be coated with a friction reducing coating: the bobbin, the guide bush, the spring means, the spring receiving bore.

In one embodiment each surface of each component of the assembly that moves in contact with the surface of another assembly component during the insertion and/or release of a tool is coated with a friction reducing coating.

Preferably the internal surface of the collet, and especially the inner tool gripping surfaces of the jaw portions of the collet are kept free of friction reducing coating.

The coating preferably has a very low coefficient of friction, say in the region of 0.1 or lower.

Preferably the coating is applied to parts using a low temperature process to avoid changing the properties of the materials of the coated components. The process may be conducted at room temperature.

Preferably the coating is thin. More preferably still, the coating is sufficiently thin that the coating may be applied after the finishing processes have been carried out on the components and, after coating, the components remain within the selected manufacturing tolerances.

Preferably the coating is applied evenly over the coated surfaces. This can ensure that the geometry of the components is maintained and there is no edge build up of coating material. The coating is preferably useable on heat treated materials without damage.

The coating is preferably compatible with at least one of, or any combination of: solvents, lubricating oils and greases.

The coating may have a hardness in the region of 30 Rc (Rockwell Hardness scale C).

The coating may be a tungsten di-sulphide coating.

An embodiment of the present invention will now be described, by way of example only, with reference to the accompanying drawings in which:
Figure 1 is a sectional view of part of a rotary tool holder assembly;
Figure 1A is a schematic representation of part of the rotary tool holder shown in Figure 1;
Figure 2 is a sectional view of a collet of the rotary tool holder assembly shown in Figure 1; and
Figure 3 is an isometric view of the collet shown in Figure 2.

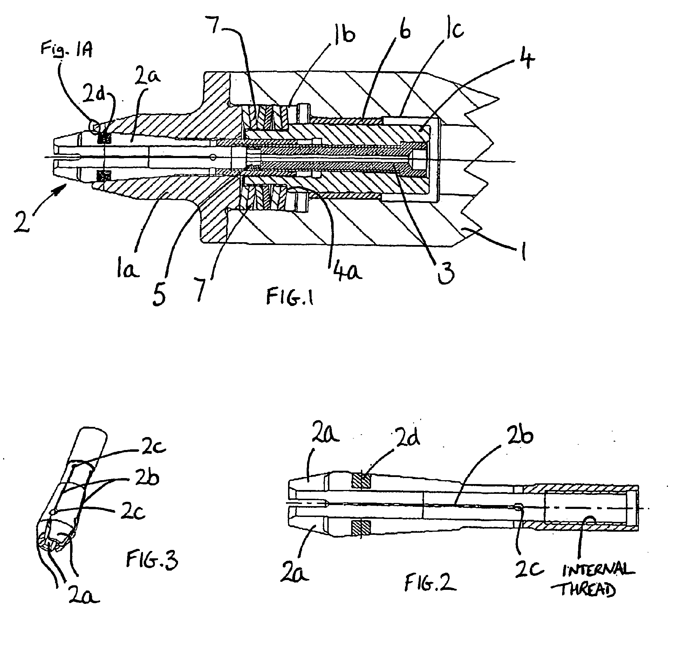

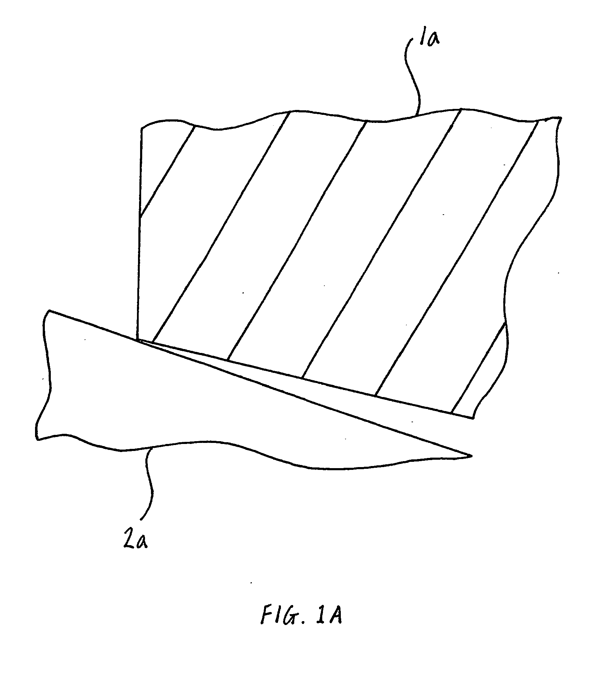

Figure 1 shows a rotary tool holder assembly which comprises a shaft 1 which carries a collet 2 for holding a tool (not shown). The collet 2 is arranged for movement within the shaft 1 between a gripping position in which an inserted tool is firmly gripped for rotation and a release position in which the tool may be relatively easily inserted into and removed from the collet 2.

The release position corresponds to the collet 2 projecting further out of the shaft 1 and the gripping position corresponds to the collet 2 being drawn back into the shaft 1. That is to say movement of the collet 2 towards the left in the orientation shown in Figure 1 will release the gripping force on an inserted tool, whereas movement to the right will increase the gripping force on an inserted tool.

As is perhaps most clearly seen in Figure 3, the collet 2 is of generally cylindrical shape and although not shown in the drawings the shaft 1 similarly has a generally cylindrical shape.

As best seen in Figure 3, the collet 2 in this embodiment comprises four jaw portions 2a which are arranged for gripping an inserted tool. Slots 2b terminating in stress relieving apertures 2c are provided in the body of the collet 2 to allow the jaw portions 2a to flex relative to the remainder of the collet 2. In other embodiments there may be differing numbers of jaws, for example there may be three, six or eight jaw portions.

A central portion of each jaw portion 2a carries an external taper which mates with an internal taper in a front portion 1 a of the shaft 1. When the collet 2 is moved axially relative to the shaft 2 these tapers interact to cause the jaws 2a to move closer to one another, to grip an inserted tool, as the collet 2 is moved into the shaft 1 and similarly allow the jaw portions 2a to move away from one another, to release an inserted tool, as the collet 2 is moved further out of the shaft 1.

Rubber inserts 2d (not shown in Figure 3) are provided in each of the jaw portions 2a to bear on the internal taper of the front portion 1a of the shaft 1. These inserts provide a dust seal to prevent or limit the ingress of dust into the assembly via the slots 2b.

The body of the shaft 1 comprises a main bore which has two portions of different diameter. The first portion of the bore is adjacent to the front portion 1a of the shaft and has a diameter which is larger than the diameter of the second portion of the bore 1c which is disposed further into the body of the shaft 1.

The collet 2 is threadingly mounted on a threaded stud 3, which itself is retained in a bobbin 4 arranged for movement within the shaft 1. The collet 2 is threaded onto the stud 3 during assembly and is locked in position using a locking grub screw 5. Thus in normal operation the collet 2, stud 3 and bobbin 4 move together relative to the shaft 1.

The collet 2, stud 3 and bobbin 4 are housed within the second portion of the main bore 1c of the shaft 1. A guide bush insert 6 is provided within the bore of the shaft 1 and is arranged to guide the movement of the bobbin 4 and hence the collet 2.

The first part of the main bore 1b houses a set of springs 7 which act on a shoulder 4a of the bobbin. The springs 7 are put under compression during assembly so that the springs 7 tend to drive the bobbin 4 further into the shaft 1 so retracting the collet 2. As described above, due to the mating tapers of the collet 2 and front portion 1a of the shaft, retraction of the collet 2 causes the collet jaw portions 2a to grip an inserted tool.

Therefore, when a tool is to be inserted into the rotary tool holder, a push rod is used to push the bobbin 4, and hence collet 2, forward such that the jaw portions 2a of the collet may spread to allow the insertion of a tool. When the force of the push rod is removed, the collet 2 and bobbin 4 retract under force of the springs 7 into the shaft 1 causing the jaws 2a to close onto and grip the inserted tool.

It will be noticed that during the movement of the bobbin 4, stud 3 and collet 2 relative to the shaft 1, there are various components which are in sliding contact with one another.

This has two implications. First of all these components are susceptible to wear and, secondly the frictional force between these sliding components must be kept to a minimum if a good gripping force is to be exerted on an inserted tool.

In the present embodiment, to give good wear characteristics and maximise the gripping force which is exerted on an inserted tool, components within the tool holder assembly are coated with a friction reducing coating.

In particular, the outer curved surfaces of the collet 2 are provided with a friction reducing coating.

Other surfaces in the tool holder assembly can also be coated with a friction reducing coating. These surfaces include: the internal curved surface of the guide bush insert 6; the taper surfaces of the front portion 1a of the shaft; the outer cylindrical surface of the bobbin 4; the internal cylindrical surface of the first part of the main bore 1b which houses the springs 7; and the whole of the surfaces of the springs 7, or at least those parts which come into contact with the bobbin 4 and/or the internal cylindrical surface of the first part of the main bore 1b.

On the other hand however, the internal cylindrical surface of the collet 2 and especially the internal surface of the jaw portions 2a is kept clean of friction reducing coating to ensure that maximum grip is exerted on an inserted tool.

The provision of friction reducing coating on these components, and first foremost on the external curved surfaces of the collet 2, in particular the taper surfaces of the collet 2, can give rise to a very low maintenance product which will retain a high gripping force on an inserted tool over a long period of time without the need for any regreasing.

The friction reducing coating should have a low coefficient of friction, preferably a very low coefficient of friction of in the region of 0.1 or lower. It is preferred that the friction reducing coating can be applied to parts using a low temperature application process, for example a room temperature application process. This is to avoid changing the material properties or conditions of the components during coating.

The coating is preferably thin, and in a preferred manufacturing process, the components are machined and finished to the desired size within chosen manufacturing tolerances and the friction reducing coating is then applied to the relevant surfaces of the components whilst staying within the manufacturing tolerances. Compared with the typical assembly tolerances (of say 2.5 microns on diameter) in devices of interest, the coating should be thin and say in the order of 0.5 microns or less.

The coating should follow the geometry of the existing machined surfaces and exhibit no edge build up.

The coating should be usable on heat treated materials without damage and, furthermore, should be compatible with solvents, lubricating oils and greases which may be used deliberately or may come into contact with the coated surfaces during assembly or use.

The coating needs to have a reasonable degree of hardness to resist handling damage. A hardness of 30 Rc (Rockwell hardness scale C) or greater is considered to be appropriate.

In preferred embodiments of the present invention the coating is a tungsten disulphide coating.

Although not shown in the drawings, the rotary tool holder assembly will be arranged to be received in a tooling machine for rotary drive. The shaft 1 therefore has journal surfaces to be received in appropriate rotary bearings and these journal surfaces can be coated with a friction reducing coating to give low friction starting and anti-scuffing where air bearings are used, and to generally assist with bearing lubrication where mechanical bearings are used.

The rotary tool holder described above with reference to Figures 1 to 3 includes a tapering mis-match between the external tapers of the jaw portions 2a and the internal taper of the front portion 1a of the shaft 1. This mis-match is not readily discernable in Figure 1 because the amount of mis-match is small compared to the dimensions of the components shown in Figure 1. This mis-match may however, be seen in Figure 1A, which is a schematic representation of part of the rotary tool holder shown in Figure 1.

Figure 1A shows part of the rotary tool holder in a stationary configuration. In this configuration the taper angle of the internal taper of the shaft 1 (which is the acute angle formed between the internal taper and the axis of the shaft) is less than the taper angle of the jaw portions 2a. The difference between the taper angle of the shaft and the taper angle of the jaw portions 2a is typically several arc minutes. Thus when the rotary tool holder is stationary the internal taper of the shaft 1 has only line contact with the taper of the jaw portions 2a at the very front of the shaft.

When the rotary tool holder is in use, it is typically rotated in excess of 80,000 rpm. At these speeds the shaft 1 tends to expand radially. This effect tends to be more pronounced towards the front end 1 a of the shaft 1 where the shaft 1 is thinner. As the shaft 1 expands, it changes shape such that the mis-match between the internal taper of the shaft 1 and the external taper of the jaw portions 2a decreases. In preferred embodiments, the arrangement is such that the mis-match disappears and the taper of the shaft and the external taper of the jaw portions 2a become the same as one another. During this process, the jaw portions 2a are urged axially into the narrow end of the internal taper of the shaft by the springs 7 causing the collet 2 to slide relative to the shaft 1. The shape of the jaw portions 2a also changes as a result of rotation and so the tapers are ideally chosen with this in mind.

The presence of the friction reducing coating on the external taper of the jaw portions and the internal taper of the shaft is advantageous as the contact forces between the front portion 1a of the shaft 1 and the jaw portions 2a are initially very high due to the small area of contact. The friction reducing coating tends to allow the collet 2 to move relative to the shaft 1 without jamming or fretting of the surfaces.

## Claims

1. A rotary tool holder assembly for high speed rotation comprising a collet (2) and a shaft (1), the collet (2) being moveable relative to the shaft (1) between a tool gripping position, in which an inserted tool can be gripped for rotation, and a tool release position, the shaft (1) comprising a bore for receiving the collet, the shaft (1) and collet (2) shaped such that when the rotary tool holder assembly is rotated at a high speed the inner surface of the shaft bore substantially fits the outer surface of the collet wherein the outer surface of the collet and the inner surface of the shaft are tapered, the collet and the shaft bore tapering radially inwardly away from a tool receiving mouth of the collet (2) **characterised in that** the tapers are such that when the rotary tool holder is stationary, the taper angle of the collet (2) is greater than the taper angle of the shaft (1) and at least one of the shaft (1) and the collet (2) is arranged such that when the rotary tool holder assembly is rotated at a high speed there is relative deformation between the outer surface of the collet and the inner surface of the shaft bore to give the substantial fit therebetween and wherein a friction reducing coating is provided between at least a portion of the inner surface of the shaft (1) and the outer surface of the collet (2).

2. A rotary tool holder assembly according to claim 1 in which at least part of an outer surface of the collet (2) which faces the inner surface of the shaft (1) bore is coated with a friction reducing coating.

3. A rotary tool holder assembly according to claim 1 or claim 2 in which the collet (2) comprises a plurality of jaw portions (2a) for gripping an inserted tool, at least one of the collet (2) and the shaft (1) are tapered so that axial movement of the collet relative to the shaft causes or allows the jaw portions (2a) of the collet to move in a direction transverse to the axis of the collet for gripping and releasing of an inserted tool.

4. A rotary tool holder assembly according to any preceding claim in which the collet (2) is carried by a bobbin (4) arranged for axial movement within a bore of the shaft.

5. A rotary tool holder assembly according to any preceding claim in which spring means (7) are provided for biasing the collet towards the gripping position.

6. A rotary tool holder assembly according to claim 4 comprising spring means (7) arranged for acting on the bobbin (4) to bias the collet towards the gripping position.

7. A rotary tool holder assembly according to claim 5 or claim 6 in which at least a portion of the spring means (7) is coated with a friction reducing coating.

8. A rotary tool holder assembly according to any one of claims 5 to 7 in which the spring means (7) is disposed in a spring receiving bore which is provided in the shaft, at least a portion of the spring receiving bore being coated with a friction reducing coating.

9. A method of producing a rotary tool holder assembly according to any preceding claim in which the friction reducing coating is applied to parts using a low temperature process to avoid changing the properties of the materials of the coated components.

## Patentansprüche

1. Eine drehende Werkzeughalteranordnung zur Hochgeschwindigkeitsdrehung, umfassend eine Hülse (2) und eine Welle (1), während die Hülse (2) in Bezug auf die Welle (1) zwischen einer Werkzeug greifenden Position, in der ein eingesetztes Werkzeug zur Drehung ergriffen werden kann, und einer Werkzeugfreigabeposition bewegbar ist, wobei die Welle (1) eine Bohrung zum Aufnehmen der Hülse umfasst, während die Welle (1) und die Hülse (2) so geformt sind, dass, wenn die drehende Werkzeughalteranordnung bei einer hohen Geschwindigkeit gedreht wird, die innere Oberfläche der Wellenbohrung im Wesentlichen mit der äußeren Oberfläche der Hülse zusammenpasst, während die äußere Oberfläche der Hülse und die innere Oberfläche der Welle sich verjüngen, wobei sich die Hülse und die Bohrung der Welle radial einwärts weg von einem Werkzeug aufnehmenden Mund der Hülse (2) verjüngen, **dadurch gekennzeichnet, dass** die Verjüngungen so sind, dass, wenn der drehende Werkzeughalter stationär ist, der Verjüngungswinkel der Hülse (2) größer ist als der Verjüngungswinkel der Welle (1) und mindestens einer von der Welle (1) und der Hülse (2) ist so angeordnet, dass, wenn die drehende Werkzeughalteranordnung bei einer hohen Geschwindigkeit gedreht wird, eine relative Deformation zwischen der äußeren Oberfläche der Hülse und der inneren Oberfläche der Bohrung der Welle auftritt, um im Wesentlichen dazwischen eine Passung bereitzustellen, während eine reibungsreduzierende Beschichtung bereitgestellt wird zwischen mindestens einem Bereich der inneren Oberfläche der Welle (1) und der äußeren Oberfläche der Hülse (2).

2. Eine drehende Werkzeughalteranordnung gemäß Anspruch 1, in der mindestens ein Teil einer äußeren Oberfläche der Hülse (2), die der inneren Oberfläche der Bohrung der Welle (1) gegenübersteht, mit einer reibungsreduzierenden Beschichtung beschichtet ist.

3. Eine drehende Werkzeughalteranordnung gemäß Anspruch 1 oder Anspruch 2, in der die Hülse (2) eine Mehrzahl von Klauenbereichen (2a) umfasst, um ein eingeführtes Werkzeug zu greifen, während mindestens eine von der Hülse (2) und der Welle (1) sich verjüngen, so dass eine axiale Bewegung der Hülse relativ zu der Welle verursacht oder gestattet, dass die Klauenbereiche (2a) der Hülse sich in eine Richtung quer zu der Achse der Hülse zum Greifen und Freigeben eines eingesetzten Werkzeugs bewegen.

4. Eine drehende Werkzeughalteranordnung gemäß einem der vorhergehenden Ansprüche, in der die Hülse (2) von einer Rolle (4) getragen wird, die für eine axiale Bewegung innerhalb einer Bohrung der Welle angeordnet ist.

5. Eine drehende Werkzeughalteranordnung gemäß einem der vorhergehenden Ansprüche, in der Federmittel (7) zum Vorspannen der Hülse in Richtung der Greifposition bereitgestellt sind.

6. Eine drehende Werkzeughalteranordnung gemäß Anspruch 4, umfassend Federmittel (7), die zum Einwirken auf die Rolle (4) angeordnet sind, um die Hülse in Richtung der greifenden Position vorzuspannen.

7. Eine drehende Werkzeughalteranordnung gemäß Anspruch 5 oder Anspruch 6, in der mindestens ein Bereich des Federmittels (7) mit einer reibungsreduzierenden Beschichtung beschichtet ist.

8. Eine drehende Werkzeughalteranordnung gemäß einem der Ansprüche 5 bis 7, in der das Federmittel (7) in einer Feder aufnehmenden Bohrung angeordnet ist, die in der Welle bereitgestellt ist, während mindestens ein Bereich der Feder aufnehmenden Bohrung mit einer reibungsreduzierenden Beschichtung beschichtet ist.

9. Ein Verfahren zum Herstellen einer drehenden Werkzeughalteranordnung gemäß einem der vorhergehenden Ansprüche, in der die reibungsreduzierende Beschichtung aufgebracht wird auf Teile unter Verwendung eines Niedertemperaturprozesses, um eine Veränderung der Eigenschaften der Materialien der beschichteten Komponenten zu verhindern.

## Revendications

1. Dispositif porte-outil rotatif pour une rotation à grande vitesse comprenant une pince (2) et un arbre (1), la pince (2) étant mobile par rapport à l'arbre (1) entre une position de serrage d'outil dans laquelle un outil inséré peut être serré pour être mis en rotation et une position de desserrement d'outil, l'arbre (1) comprenant un alésage pour recevoir la pince, l'arbre (1) et la pince (2) étant appropriés de sorte quand le dispositif porte-outil rotatif est tourné à grande vitesse, la surface interne de l'alésage d'arbre s'ajuste essentiellement à la surface externe de la pince dans laquelle la surface externe de la pince et la surface interne de l'arbre sont coniques, la pince et l'arbre étant coniques radialement vers l'intérieur en s'éloignant d'un bec de logement d'outil de la pince (2) **caractérisé en ce que** les cônes sont prévus de sorte que quand le porte-outil rotatif est stationnaire, l'angle conique de la pince (2) est supérieur à l'angle conique de l'arbre (1) et au moins l'arbre (1) ou la pince (2) est disposé de sorte que quand le dispositif porte-outil est tourné à grande vitesse il se produit une déformation relative entre la surface externe de la pince et la surface interne de l'alésage d'arbre pour donner un ajustement essentiel entre eux et dans lequel un revêtement réducteur de friction est prévu entre au moins une portion de la surface interne de l'arbre (1) et la surface externe de la pince (2).

2. Dispositif porte-outil rotatif selon la revendication 1 dans lequel au moins une partie d'une surface externe de la pince (2) qui fait face à la surface interne de l'alésage de l'arbre (1) est dotée d'un revêtement réducteur de friction.

3. Dispositif porte-outil selon la revendication 1 ou la revendication 2, dans lequel la pince (2) comprend une pluralité de portions formant une mâchoire (2a) pour serrer un outil inséré, au moins la pince (2) ou l'arbre (1) sont coniques de sorte que le mouvement axial de la pince par rapport à l'arbre provoque ou permet aux portions formant mâchoire (2a) de la pince de se déplacer dans une direction transversale à l'axe de la pince pour serrer et desserrer un outil introduit.

4. Dispositif porte-outil selon l'une des revendications précédentes, dans lequel la pince (2) est portée par une bobine (4) appropriée pour effectuer un mouvement axial à l'intérieur de l'alésage de l'arbre.

5. Dispositif porte-outil selon l'une des revendications précédentes, dans lequel des moyens ressort (7) sont prévus pour précontraindre la pince vers la position de serrage.

6. Dispositif porte-outil selon la revendication 4, comprenant des moyens ressort (7) appropriés pour agir sur la bobine (4) pour précontraindre la pince en direction de la position de serrage.

7. Dispositif porte-outil selon la revendication 5 ou la revendication 6, dans lequel au moins une portion des moyens ressorts (7) est dotée d'un revêtement réducteur de friction.

8. Dispositif porte-outil selon l'une des revendications 5 à 7, dans lequel le moyen ressort (7) est disposé dans un alésage recevant le ressort qui est ménagé dans l'arbre, au moins une portion du ressort recevant l'alésage étant dotée d'un revêtement réducteur de friction.

9. Procédé de fabrication d'un dispositif porte-outil selon l'une des revendications précédentes dans lequel le revêtement réducteur de friction est appliqué sur des pièces utilisant un processus à basse température pour éviter de changer les propriétés des matériaux des composants revêtus.
